Europäisches Patentamt

European Patent Office

Office européen des brevets

(11) Veröffentlichungsnummer: **0 371 400**
**A2**

## EUROPÄISCHE PATENTANMELDUNG

(21) Anmeldenummer: 89121666.5

(51) Int. Cl.⁵: **H03K 5/08**

(22) Anmeldetag: 23.11.89

(30) Priorität: 28.11.88 DE 3840111

(43) Veröffentlichungstag der Anmeldung:
06.06.90 Patentblatt 90/23

(84) Benannte Vertragsstaaten:
DE FR GB IT SE

(71) Anmelder: Deutsch-Französisches
Forschungsinstitut Saint-Louis
12, rue de l'Industrie
F-68301 Saint-Louis Cédex(FR)

(72) Erfinder: Damp, Stephan
Brelauer Strasse 22
D-7858 Weil Am Rhein(DE)

(74) Vertreter: Schwabe, Hans-Georg, Dipl.-Ing. et
al
Patentanwälte Schwabe, Sandmair, Marx
Stuntzstrasse 16
D-8000 München 80(DE)

(54) Verfahren und Schaltungsanordnung zur Digitalisierung des höherfrequenten Anteils eines elektrischen Signals mit überlagertem variierenden Gleichsignalanteil.

(57) Bei einem Verfahren und einer Schaltungsanordnung zur Digitalisierung des höherfrequenten Anteils eines elektrischen Signals mit überlagertem variierenden Gleichsignalanteil wird der aktuelle Signalverlauf mit einem gespeicherten, zuletzt aufgetretenen lokalen Minimal- oder Maximalwert des Signalwerts verglichen und in bezug auf den neu auftretenden Minimal- oder Maximalwert digitalisiert.

## FIG.2

EP 0 371 400 A2

## Verfahren und Schaltungsanordnung zur Digitalisierung des höherfrequenten Anteils eines elektrischen Signals mit überlagertem variierenden Gleichsignalanteil

Die Erfindung betrifft ein Verfahren und eine Schaltungsanordnung zur Digitalisierung des höherfrequenten Anteils eines elektrischen Signals mit überlagertem variierenden Gleichsignalanteil.

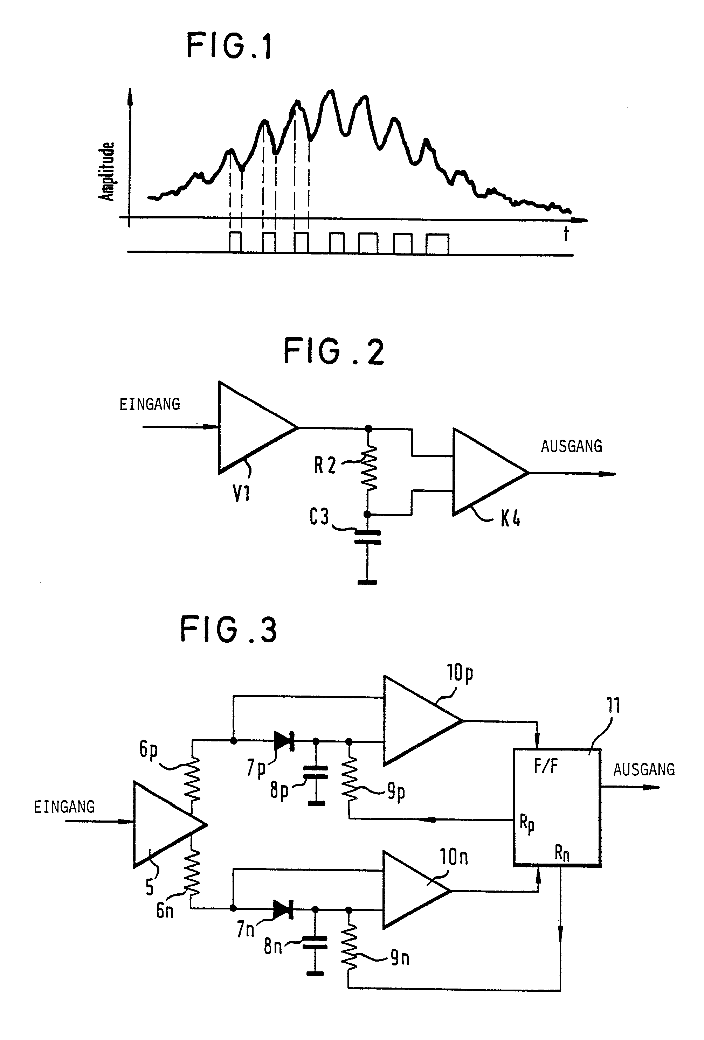

Ein Beispiel für ein derartiges elektrisches Signal ist oben in Figur 1 schematisch dargestellt. Es ist zu erkennen, daß dem eigentlich interessierenden Wechselsignal ein langsam variierendes Gleichsignal überlagert ist, welches etwa die Form einer Gaußverteilung hat. Es ist daher für eine Weiterverarbeitung des interessierenden Wechselanteils erforderlich, daß dieser vom gaußförmigen Gleichanteil abgetrennt wird. Dies kann etwa mit Hilfe von schaltbaren Filterbänken erfolgen, wobei gleichzeitig die Rauschbandbreite verkleinert wird. Allerdings sind hierfür verhältnismäßig umfangreiche, also aufwendige, Schaltungsanordnungen erforderlich, die entsprechend hohe Kosten zur Folge haben und viel Platz benötigen. von besonderer Bedeutung ist jedoch, daß derartige schaltbare Filterbänke in geeigneter Weise eingestellt werden müssen, so daß eine unsachgemäße Bedienung das Ergebnis der Trennung verfälschen kann.

Zur Weiterverarbeitung des gefilterten Signals erfolgt häufig eine Digitalisierung, wobei in vielen Fällen eine Ein-Bit-Analog/Digital-Wandlung ausreicht. Im unteren Teil von Figur 1 ist das gewünschte Ergebnis einer Ein-Bit-Digitalisierung des oberen Signals dargestellt.

Der Erfindung liegt die Aufgabe zugrunde, ein Verfahren und eine Schaltungsanordnung zur Verfügung zu stellen, welche nur wenig Schritte beziehungsweise nur verhältnismäßig wenige Bauteile erfordern.

Der Erfindung liegt die Erkenntnis zugrunde, daß es zur Lösung des gestellten Problems vorteilhaft ist, sich der Extremwerte, also der Maxima und Minima des Wechselsignals, zu bedienen.

Bezüglich des Verfahrens wird die Aufgabe gelöst durch ein Verfahren zur Digitalisierung des höherfrequenten Anteils eines elektrischen Signals mit überlagertem variierenden Gleichsignalanteil, bei welchem zunächst die Erfassung eines ersten momentanen Extremwerts des Signals erfolgt, sodann die Erfassung eines zweiten, zeitlich nach dem ersten Extremwert liegenden zweiten momentanen Extremwerts des Signals, dann die Feststellung der Beziehung zwischen dem ersten Extremwert und dem zweiten Extremwert, und schließlich eine Digitalisierung auf der Grundlage der festgestellten Beziehung zwischen dem ersten Extremwert, und dem zweiten Extremwert. Statt der Estremwerte können auch Signalwerte erfaßt werden, die um einen festen Zeitraum gegenüber den Extremwerten verschoben sind. Der Zeitraum kann konstant und/oder von der Signalfrequenz abhängig sein.

Es wird daher der aktuelle Signalverlauf mit dem zuletzt aufgetreten lokalen Minimal- oder Maximalwert des Signals verglichen, und die Digitalisierung erfolgt in bezug auf den neu auftretenden Minimal- oder Maximalwert.

Die lokalen Extremwerte können digital oder analog gespeichert werden. Ein weiterer Vorteil des erfindungsgemäßen Verfahrens liegt darin, daß der Kurvenverlauf in absoluten oder in relativen Einheiten, bezogen auf die Extremwerte, digitalisiert werden kann.

Insbesondere ist es bei dem erfindungsgemäßen Verfahren nicht erforderlich, im jeweiligen Anwendungsfall hieran angepaßte Einstellungen vorzunehmen, wie etwa nach dem Stand der Technik bei schaltbaren Filterbänken; bei dem erfindungsgemäßen Verfahren sind daher Bedienungsfehler ausgeschlossen.

Die Beziehung zwischen dem ersten Extremwert und dem zweiten Extremwert kann einfach die Differenz zwischen den beiden Werten sein. Dagegen ist es für eine Digitalisierung in relativen Einheiten vorteilhaft, wenn als Beziehung zwischen dem ersten und dem zweiten Extremwert deren Verhältnis gewählt wird.

Vorzugsweise wird für den Vergleich der beiden Extremwerte jeweils ein Maximal- mit einem Minimalwert beziehungsweise ein Minimal- mit einem Maximalwert verglichen. Die Feststellung eines Extremwerts kann durch eine Bestimmung des Vorzeichenwechsels der Signalflanken erfolgen.

Bezüglich der Schaltungsanordnung wird die aufgabe gelöst durch eine Schaltungsanordnung zur Digitalisierung des höherfrequenten Anteils eines elektrischen Signals mit überlagertem variierenden Gleichsignalanteil, bei welcher eine Speichereinrichtung für einen Extremwert des elektrischen Signals vorgesehen ist, eine Einrichtung zur Erfassung eines momentanen Signalwerts, und eine an die Speichereinrichtung und die Einrichtung zur Erfassung eines momentanen Signalwerts angeschlossene Vergleichseinrichtung.

Die voranstehend im Zusammenhang mit dem erfindungsgemäßen Verfahren angegebenen Vorteile gelten sinngemäß selbstverständlich auch für die erfindungsgemäße Schaltungsanordnung.

Der geringe Bauteilaufwand der erfindungsgemäßen Schaltungsanordnung wird insbesondere dann deutlich, wenn die Speicher einrichtung ein Kondensator ist und/oder die Einrichtung zur Erfassung des momentanen Signalwerts ein Widerstand;

der Widerstand und der Kondensator sind vorzugsweise als RC-Glied in Reihe geschaltet. Zur Erfassung der Signalflanke dient vorzugsweise eine Diode.

Vorteilhafterweise ist die Vergleichseinrichtung ein Komparator. Die erfindungsgemäße Schaltungsanordnung läßt sich als "Nachlaufkomparator" bezeichnen, bei welchem der aktuelle Signalverlauf mit dem gespeicherten, zuletzt aufgetretenen lokalen Minimal- oder Maximalwert des Signals verglichen und in bezug zu dem neu auftretenden Minimal-oder Maximalwert digitalisiert wird.

Gemäß einer weiteren vorteilhaften Ausgestaltung der erfindungsgemäßen Schaltungsanordnung sind ein erster Schaltungszweig zur Überwachung positiver Extremwerte und ein zweiter Schaltungszweig zur Überwachung negativer Extremwerte vorgesehen, wobei die beiden Schaltungszweige an eine Umschalteinrichtung angeschlossen sind, die in Reaktion auf die von den beiden Schaltungszweigen abgegebenen Signale zur Erzeugung eines digitalen Ausgangssignals umschaltet. Hierbei sind vorzugsweise der erste und zweite Schaltungszweig in einander entsprechender Weise aufgebaut. Ähnlich wie bei der voranstehend beschriebenen ersten Ausführungsform der erfindungsgemäßen Schaltungsanordnung weist vorteilhafterweise der erste beziehungsweise zweite Schaltungszweig einen Komparator auf, an dessen einem Eingang das Signal anliegt und dessen anderer Eingang an ein Speicherglied, etwa ein RC-Glied angeschlossen ist, das vom Signal beaufschlagt wird.

Die Umschalteinrichtung kann etwa durch ein einfaches Flipflop realisiert werden, dessen beide Eingänge von je einem der beiden Schaltungszweige beaufschalgt werden. Vorzugsweise wird das Eingangssignal für die erfindungsgemäße Schaltungsanordnung zunächst auf einen bipolaren Verstärker gegeben, an dessen beiden Ausgängen je einer der beiden Schaltungszweige zur Überwachung positiver beziehungsweise negativer Extremwerte angeschlossen ist.

Die Erfindung wird nachstehend anhand zeichnerisch dargestellter Ausführungsbeispiele näher erläutert, aus welchen sich weitere Vorteile und Merkmale ergeben.

Es zeigen :

Fig. 1 eine schematische Darstellung des zeitlichen Verlaufs eines Wechselspannungssignals, welchem ein entsprechend einer Gaußkurve variierender Gleichspannungsanteil überlagert ist;

Fig. 2 eine erste Ausführungsform einer erfindungsgemäßen Schaltungsanordnung; und

Fig. 3 eine zweite Ausführungsform einer erfindungsgemäßen Schaltungsanordnung mit zwei Schaltungszweigen.

Bei der in Figur 2 dargestellten Ausführungsform einer erfindungsgemäßen Schaltungsanordnung ist am Eingang ein Pufferverstärker V1 vorgesehen, dem ein RC-Glied R2, C3 nachgeschaltet ist. Die an dem Widerstand R2 abfallende Spannung wird über einen Komparator K4 abgegriffen, an dessen Ausgang ein entsprechendes Digitalsignal zur Verfügung steht.

Die dargestellte Schaltungsanordnung arbeitet so, daß der Kondensator C3 einen zeitlich vorlaufenden Signalspannungswert speichert. Abhängig davon, ob die Signalspannung lokal ansteigt oder abfällt, erfolgt ein entsprechender Spannungsabfall am Widerstand R2 mit entsprechender Stromrichtung, und zwar unabhängig von einem möglicherweise dem Eingangswechselsignal überlagerten Gleichsignalanteil.

Die dargestellte Schaltungsanordnung führt daher zu einer Ein-Bit-Digitalisierung und ist auch in dieser Hinsicht besonders einfach.

Allerdings wird der Betrieb der in Figur 2 dargestellten Schaltungsanordnung dadurch beschränkt, daß bei niedrigen Frequenzen die Anstiegsgeschwindigkeit der über dem Widerstand R2 abfallenden Spannung so gering ist, daß der Komparator K4 zu schwingen anfängt. Ein zuverlässiger Betrieb der in figur 2 dargestellten Schaltungsanordnung ist etwa über einen Bereich eines Frequenzverhältnisses von etwa 1 : 20 möglich.

Diese Schwierigkeiten bei niedrigen Frequenzen lassen sich mit der in Figur 3 dargestellten Ausführungsform der erfindungsgemäßen Schaltungsanordnung überwinden.

Am Eingang der Schaltungsanordnung gemäß Figur 3 ist ein bipolarer Pufferverstärker 5 vorgesehen, der das am Eingang anliegende Signal bipolar auf seine beiden Ausgänge ausgibt. Ein erster Schaltungsteil in der oberen Hälfte der Figur 3 überwacht lokale Maxima eines Wechsel spannungssignals und ist hierzu insgesamt durch einen Kennbuchstaben "p" gekennzeichnet, wogegen ein weiterer, in der unteren Hälfte der Figur 3 gezeigter Schaltungsteil die lokalen Minima überwacht und mit einem Kennbuchstaben "n" bezeichnet ist.

Im Schaltungsteil zur überwachung der Maxima ist ein Widerstand 6p zur Lastangleichung un Strombegrenzung des Ausgangs des Verstärkers 5 vorgesehen. An den Widerstand 6p ist einmal direkt ein Eingang eines Komparators 10p angeschlossen, dessen anderer Anschluß über eine Diode 7p mit dem Widerstand 6P verbunden ist. Zwischen der Diode und dem zugehörigen eingang des Komparators 10p sind ein zwischen die Diode und Masse geschalteter Kondensator 8p und ein Widerstand 9p vorgesehen, dessen anderer Anschluß mit einem Rücksetzausgang Rp eines Flipflops 11 verbunden ist.

Der zweite Schaltungszweig zur Überwachung der Minima ist entsprechend aufgebaut und weist demzufolge einen Widerstand 6n auf, einen Komparator 10n, eine Diode 7n, einen Kondensator 8n und einen Widerstand 9n, der an einen weiteren Rücksetzausgang Rn des Flipflops 11 angeschlossen ist.

Die Ausgänge der beiden Komparatoren 10p, 10n sind jeweils an einen Eingang des Flipflops 11 angeschlossen; am Ausgang des Flipflops 11 liegt das gewünschte digitalisierte Ausgangssignal an.

Die Funktionsweise der in Figur 3 dargestellten Schaltungsanordnung ist wie folgt: im (positiven) Zweig "p" lädt eine ansteigenden Flanke des über den bipolaren Verstärker 5 zugeführten Eingangssignals über den Strombegrenzungswiderstand 6p und die Diode 7p den Kondensator 8p auf. Der Spannungsabfall über der Diode 7p hält den Komparator 10p im AUS-Zustand.

Wenn nun die Signalspannung abfällt, so wird im Kondensator 8p der Wert des gerade aufgetretenen lokalen Maximums, verringert um die Durchlaßspannung der Diode 7p, gespeichert. Unterschreitet die Signalspannung diesen Wert, so schaltet der Komparator 10p in den EIN-Zustand und führt damit zu einem Zustandswechsel des Flipflops 11.

Der Zustandswechsel des Flipflops 11 führt gleichzeitig über eine entsprechende Schaltfunktion zum Aktivieren des Rücksetzausgangs Rp, so daß über den Widerstand 9p nunmehr der Kondensator 8p zur Masse hin entladen wird, wodurch der Komparator 10p wieder in den AUS-Zustand zurückgeht und der Kondensator 8p freigegeben wird.

Die andere (negative) Schaltungshälfte "n" zur Überwachung der Minima überwacht dadurch, daß das eingangssignal in diesem Zweig vom bipolaren Verstärker 5 invers zur Verfügung gestellt wird, die lokalen Minima in analoger Weise. Beim Einschalten des Komparators 10n wechselt das Flipflop 11 erneut seinen Zustand, womit gleichzeitig über den Rücksetzausgang Rn über den Widerstand 9n der Kondensator 8n nach Masse entladen und dann der Kondensator 8n für einen neuen Ladezyklus freigegeben wird.

Die Dioden 7p, 7n führen zu einer hysterese der in Figur 3 dargestellten Schaltungsanordnung in Größe der Durchlaßspannung der Dioden. Hierdurch ergibt sich ein sehr stabiler, schwingungsfreier Betrieb der Komparatoren 10p, 10n. Darüber hinaus wird diese Schaltungsanordnung weniger empfindlich gegenüber überlagertem Rauschen, das bis zur Größe der halben Dioden-Durchlaßspannung unterdrückt wird. Werden statt der Dioden schnelle Analogschalter eingesetzt, so läßt sich - allerdings mit höherem Aufwand -eine beliebig auswählbare Hysterese erreichen.

Es wird darauf hingewiesen, daß statt eines bipolaren Verstärkers 5 im Eingangsteil der Schaltungsanordnung gemäß Figur 3 auch ein unipolarer Verstärker vorgesehen werden kann, wodurch dann die Schaltung in analoger Weise so auszulegen wäre, daß ein Schaltungszweig nicht mehr auf Masse, sondern auf positives Potential bezogen ist.

Bei allzu hohen Frequenzen würde sich bei der in Figur 3 dargestellten Schaltungsanordnung keine genügende Aufladung der Kondensatoren 8p, 8n ergeben, bedingt durch die Widerstände 6p, 6n und die Dioden. Dadurch, daß die Widerstände 9p, 9n die Entladung bei hohen Frequenzen beschränken, wird bei der in Figur 3 dargestellten Schaltungsanordnung ein ähnliches Verhalten wie bei der in Figur 2 gezeigten Schaltungsanordnung für hohe Frequenzen erreicht. Daher kann die in Figur 3 dargestellte Schaltungsanordnung bei Signalfrequenzverhältnissen von 1 : 1000 oder mehr betrieben werden.

Es ist ebenfalls möglich, bei der in figur 3 dargestellten Schaltungsanordnung statt einer einfachen Entladung des jeweiligen Kondensators 8p beziehungsweise 8n den gerade zu löschenden Kondensator auf den jeweils anderen Extremwert nachzuführen, also eine aktive Umladung vorzunehmen.

## Ansprüche

1. Verfahren zur Digitalisierung des höherfrequenten Anteils eines elektrischen Signals mit überlagertem variierenden Gleichsignalanteil, **gekennzeichnet** durch folgende Schritte:

(a) Erfassung eines ersten momentanen Extremwerts des Signals;

(b) Erfassung eines zweiten momentanen Extremwerts des Signals zeitlich nach dem ersten Extremwert liegend;

(c) Feststellung der Beziehung zwischen dem ersten Extremwert und dem zweiten Extremwert; und

(d) Digitalisierung auf der Grundlage der festgestellten Beziehung zwischen dem ersten Extremwert und dem zweiten Extremwert.

2. Verfahren nach Anspruch 1, dadurch **gekennzeichnet**, daß im Schritt (c) die Differenz zwischen dem ersten Extremwert und dem zweiten Extremwert festgestellt wird.

3. Verfahren nach Anspruch 1, dadurch **gekennzeichnet**, daß im Schritt (c) das Verhältnis des zweiten Extremwerts zum ersten Extremwert festgestellt wird.

4. Verfahren nach einem der Ansprüche 1 bis 3, dadurch **gekennzeichnet**, daß der erste Extremwert ein Maximal-(Minimal-)Wert und der zweite Extremwert ein Minimal-(Maximal-)Wert ist.

5. Schaltungsanordnung zur Digitalisierung des höherfrequenten Anteils eines elektrischen Signals mit überlagertem variierenden Gleichsignalanteil, dadurch **gekennzeichnet**, daß eine Speichereinrichtung (C3) für einen Extremwert des elektrischen Signals vorgesehen ist, eine Einrichtung (R2) zur Erfassung eines momentanen Signalwerts, und eine an die Speichereinrichtung (C3) und die Einrichtung (R2) angeschlossene Vergleichseinrichtung (K4).

6. Schaltungsanordnung nach Anspruch 5, dadurch **gekennzeichnet**, daß die Speichereinrichtung ein Kondensator (C3) ist.

7. Schaltungsanordnung nach Anspruch 5 oder 6, dadurch **gekennzeichnet**, daß die Einrichtung zur Erfassung des momentanen Signalwerts einen Widerstand (R2) aufweist sowie eine weitere Einrichtung, die bei Feststellung einer Vorzeichenumkehr des Signalwerts das Vorliegen eines Extremwerts anzeigt.

8. Schaltungsanordnung nach Anspruch 7, dadurch **gekennzeichnet**, daß der Widerstand (R2) in Reihe mit dem Kondensator (C3) geschaltet ist.

9. Schaltungsanordnung nach einem der Ansprüche 5 bis 8, dadurch **gekennzeichnet**, daß die Vergleichseinrichtung ein Komparator (K4) ist.

10. Schaltungsanordnung nach Anspruch 5, dadurch **gekennzeichnet**, daß ein erster Schaltungszweig (p) zur Überwachung positiver Extremwerte und ein zweiter Schaltungszweig (n) zur Überwachung negativer Extremwerte vorgesehen sind, wobei die beiden Schaltungszweige (p, n) an eine Umschalteinrichtung (11) angeschlossen sind, die in Reaktion auf die von den Schaltungszweigen (p, n) abgegebenen Signale zur Erzeugung eines digitalen Ausgangssignals umschaltet.

11. Schaltungsanordnung nach Anspruch 10, dadurch **gekennzeichnet**, daß der erste und zweite Schaltungszweig (p, n) in einander entsprechender Weise aufgebaut sind.

12. Schaltungsanordnung nach Anspruch 10 oder 11, dadurch **gekennzeichnet**, daß der erste Schaltungszweig (p) einen Komparator (10p) aufweist, an dessen einem Eingang das Signal anliegt und dessen anderer Eingang an ein RC-Glied (9p, 8p) angeschlossen ist, das vom Signal beaufschlagt wird.

13. Schaltungsanordnung nach einem der Ansprüche 10 bis 12, dadurch **gekennzeichnet**, daß der zweite Schaltungszweig (n) einen Komparator (10n) aufweist, an dessen einem Eingang das Signal anliegt und dessen anderer Eingang an ein RC-Glied (9n, 8n) angeschlossen ist, das vom Signal beaufschlagt wird.

14. Schaltungsanordnung nach einem der Ansprüche 10 bis 13, dadurch **gekennzeichnet**, daß die Umschalteinrichtung ein Flipflop (11) ist.

15. Schaltungsanordnung nach einem der Ansprüche 10 bis 14, dadurch **gekennzeichnet**, daß eingangsseitig ein bipolarer Verstärker (5) vorgesehen ist, an dessen beide Ausgänge je ein Schaltungszweig (p, n) angeschlossen ist.

16. Schaltungsanordndung nach einem der Ansprüche 12 bis 15, dadurch **gekennzeichnet**, daß in jedem Schaltungszweig (p, n) dem RC-Glied (9p, 8p; 9n, 8n) eine Diode (7p, 7n) vorgeschaltet ist.

17. Schaltungsanordnung nach Anspruch 16, dadurch **gekennzeichnet**, daß die Diode (7p; 7n) die positive beziehungsweise negative Signalflanke feststellt.

18. Schaltungsanordnung nach einem der Ansprüche 5 bis 17, dadurch **gekennzeichnet**, daß die Speichereinrichtung (8p, 8n) durch eine Entladeschaltung (11, Rp, 9p; 11, Rn, 9n) aktiv entladen wird.

19. Schaltungsanordnung nach Anspruch 18, dadurch **gekennzeichnet**, daß des Flipflop (11) die Entladung steuert.

20. Schaltungsanordnung nach Anspruch 18 oder 19, dadurch **gekennzeichnet**, daß die Entladung über jeweils einen Widerstand (9p, 9n) erfolgt.

21. Schaltungsanordnung nach einem der Ansprüche 5 bis 17, dadurch **gekennzeichnet**, daß die Speichereinrichtung (8p, 8n) nach Erkennen des zugehörigen Extremwerts aktive auf den Wert der anderen Speichereinrichtung (8n, 8p) geladen wird.

# FIG.1

# FIG.2

EINGANG

V1

R2

C3

K4

AUSGANG

# FIG.3

10p

11

6p

7p

8p

9p

F/F

AUSGANG

EINGANG

5

$R_p$

6n

$R_n$

10n

7n

8n

9n